(19) Europäisches Patentamt
European Patent Office
Office européen des brevets

(11) EP 2 157 605 B1

(12) EUROPEAN PATENT SPECIFICATION

(45) Date of publication and mention of the grant of the patent:
**13.07.2016 Bulletin 2016/28**

(51) Int Cl.:
*H01L 23/02* (2006.01)      *B81C 1/00* (2006.01)
*B81C 3/00* (2006.01)      *H01L 23/00* (2006.01)

(21) Application number: **08721431.8**

(86) International application number:
**PCT/JP2008/054011**

(22) Date of filing: **06.03.2008**

(87) International publication number:
**WO 2008/149584 (11.12.2008 Gazette 2008/50)**

(54) **ELECTRONIC PART APPARATUS AND PROCESS FOR MANUFACTURING THE SAME**

ELEKTRONIKTEILEVORRICHTUNG UND PROZESS ZU IHRER HERSTELLUNG

APPAREIL ÉLECTRONIQUE ET PROCÉDÉ DE FABRICATION ASSOCIÉ

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **04.06.2007 JP 2007147624**

(43) Date of publication of application:
**24.02.2010 Bulletin 2010/08**

(73) Proprietor: **Murata Manufacturing Co. Ltd.**
**Kyoto 617-8555 (JP)**

(72) Inventors:
• **KIMURA, Yuji**
**Nagaokakyo-shi**
**Kyoto 617-8555 (JP)**
• **HORIGUCHI, Hiroki**
**Nagaokakyo-shi**
**Kyoto 617-8555 (JP)**

(74) Representative: **Reeve, Nicholas Edward**
**Reddie & Grose LLP**
**16 Theobalds Road**
**London WC1X 8PL (GB)**

(56) References cited:
**JP-A- 2004 194 290      JP-A- 2006 135 264**
**JP-A- 2006 268 870      US-A- 6 046 074**
**US-A1- 2006 138 532      US-A1- 2006 186 550**
**US-A1- 2007 089 811**

**Description**

The present invention relates to an electronic component device and a method for producing the same, and particularly relates to an electronic component device having a structure in which conductor films containing high melting point metals are bonded to each other using a low melting point metal and a method for producing the same.

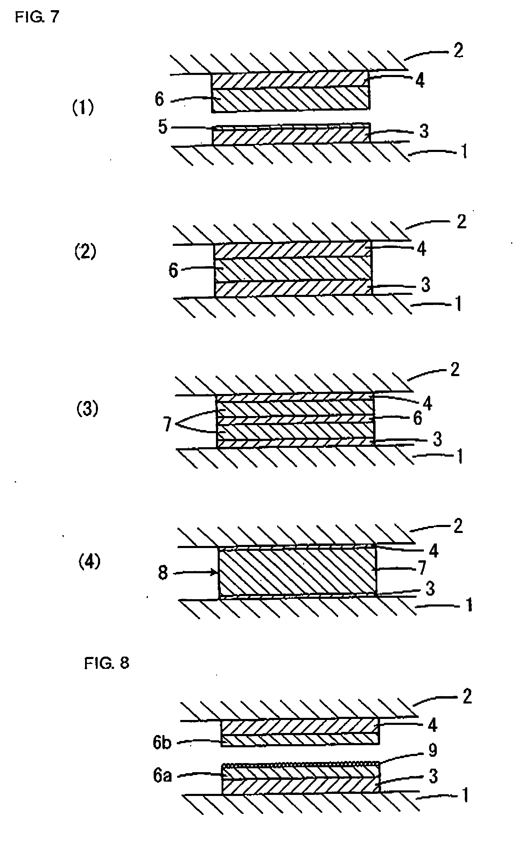

As a method for producing an electronic component device relevant to the background of the invention, a method having a process illustrated in Fig. 7 is mentioned. Fig. 7 illustrates a process for bonding a first component 1 and a second component 2 to each other that are to be provided in an electronic component device. Such a process is described in, for example, Japanese Unexamined Patent Application Publication No. 2002-110726. The first component 1 illustrated in Fig. 7 is, for example, a semiconductor chip in embodiments described in JP 2002-110726 and the second component 2 is, for example, a substrate for carrying a semiconductor chip.

In a stage before bonding the first component 1 and the second component 2 to each other, a first conductor film 3 is formed on the first component 1 and a second conductor film 4 is formed on the second component 2 as illustrated in Fig. 7(1). The first and second conductor films 3 and 4 contain high melting point metals, such as Cu, for example. On the first conductor film 3, an oxidation preventing film 5 containing, for example, Au is formed. The oxidation preventing film 5 prevents oxidation of Cu when the first conductor film 3 contains Cu as described above. In contrast, on the second conductor film 4, a low melting point metal layer 6 containing a low melting point metal having a melting point lower than that of the high melting point metal is formed. The low melting point metal layer 6 functions as a bonding material, and contains, for example, Sn.

In order to bond the first conductor film 3 and the second conductor film 4 to each other, heating is performed at a temperature between the melting point of the high melting point metals constituting the conductor films 3 and 4 and the melting point of the low melting point metal constituting the low melting point metal layer 6 while arranging the first conductor film 3 and the second conductor film 4 in such a manner as to face each other with the low melting point metal layer 6 being interposed therebetween as illustrated in Fig. 7(1). As a result, first, Au constituting the oxidation preventing film 5 dissolves in the low melting point metal layer 6, whereby the state illustrated in Fig. 7(2) is achieved.

When the heating is further continued, the high melting point metals constituting the first and second conductor film 3 and 4 are diffused in the low melting point metal layer 6 to form an intermetallic compound of the high melting point metals and the low melting point metal. Then, as illustrated in Fig. 7(3), intermetallic compound layers 7 are formed between each of the first and second conductor films 3 and 4 and the low melting point metal layer 6. Then, finally, the low melting point metal layer 6 disappears, and a bonding portion 8 in which the first conductor film 3 and the second conductor film 4 are bonded to each other through the intermetallic compound layer 7 is formed as illustrated in Fig. 7(4).

The low melting point metal layer 6 has a function of absorbing the variation in the interval between the first conductor film 3 and the second conductor film 4. Therefore, the low melting point metal layer 6 is required to have a thickness larger than a given thickness. However, as the thickens of the low melting point metal layer 6 increases, it takes a longer time to diffuse the high melting point metal in the low melting point metal layer 6, resulting in a problem of reducing the productivity.

In contrast, when the low melting point metal layer 6 is formed to be thin in order to solve the problem, the ability to absorb the variation in the interval between the first conductor film 3 and the second conductor film 4 is reduced, resulting in another problem of easily generating a poor bonding portion.

Moreover, it is known that the intermetallic compound formed in the intermetallic compound layer 7 is generally hard and fragile compared with pure metals. For example, as intermetallic compounds generated by combining of Cu and Sn, $Cu_6Sn_5$, $Cu_3Sn$, etc., are mentioned. However, when the diffusion amount of Cu in Sn is not sufficient, $Cu_6Sn_5$ that is particularly fragile among the above is likely to generate. When a stress originating from, for example, thermal expansion differences occurs between the first component 1 and the second component 2, the distortion cannot be absorbed, and thus cracking occurs in a portion where $Cu_6Sn_5$ has generated, which sometimes causes poor conduction.

In contrast, in order to shorten the time required for bonding between the first conductor film 3 and the second conductor film 4, Japanese Unexamined Patent Application Publication No. 2007-19360 has proposed a method as illustrated in Fig. 8. Fig. 8 is a figure corresponding to Fig. 7(1). In Fig. 8, components equivalent to those illustrated in Fig. 7 are designated by the same reference characters, and the duplicated descriptions are omitted.

Referring to Fig. 8, the first conductor film 3 is formed on the first component 1, and a first low melting point metal layer 6a is formed on the first conductor film 3. In contrast, the second conductor film 4 is formed on the second component 2, and a second low melting point metal layer 6b is formed on the second conductor film 4. Then, a metal powder 9 containing a high melting point metal is supplied onto, for example, the first low melting point metal layer 6a.

For bonding the first component 1 and the second component 2 to each other, heating is performed while the first and second low melting point metal layers 6a and 6b are positioned with the metal powder 9 being interposed therebetween and then the first conductor film 3 and the second conductor film 4 are made to face each other with the low melting point metal layers 6a and 6b being interposed therebetween. Thus, the high melting point metal is diffused in each of the low melting point metal layers 6a and 6b not only from the first and second conductor films 3 and 4 but also the metal powder 9 to form an intermetallic compound. Therefore, the time required for diffusing the high melting point metal throughout the low melting point metal layers 6a and 6b can be shortened.

However, according to the method illustrated in Fig. 8, when the supply amount of the metal powder 9 varies, it becomes difficult to uniformly grow the intermetallic compound from the interface between the first and second low melting point metal layers 6a and 6b. In the case where Cu is used as the high melting point metal and Sn is used as the low melting point metal and the supply amount of the metal powder 9 is not sufficient for the formation of $Cu_3Sn$, fragile $Cu_6Sn_5$ is likely to generate and, due to the same reasons as described in Japanese Unexamined Patent Application Publication No. 2002-110726 above, cracking is likely to occur, sometimes causing poor conduction. US2006/0186550, US2006/0138532 and US2007/0089811 disclose techniques resulting in formation of intermetallic compounds containg $Cu_6Sn_5$.

We have appreciated it would be desirable to provide a method for producing an electronic component device capable of solving the problems described above, and an electronic component device that can be advantageously produced by the above-described production method.

SUMMARY OF THE INVENTION

The invention is defined in the claims to which reference should now be made. Advantageous features are set forth in the dependent claims.

In a first aspect, there is provided a method for producing an electronic component device, comprising: a process for individually preparing a first component on which a first conductor film containing a first high melting point metal is formed and a second component on which a second conductor film containing a second high melting point metal is formed, wherein the first high melting point metal and the second high melting point metal are the same; a low melting point metal layer forming process for forming, on at least one of the first and second conductor films, a first low melting point metal layer containing a low melting point metal having a melting point lower than that of the first and second high melting point metals; and a high melting point metal layer forming process for forming a high melting point metal layer containing the same high melting point metal as the first and second high melting point metals in such a manner as to contact the low melting point metal layer, the low melting point metal layer forming process further including a process for forming a second low melting point metal layer in such a manner that the high melting point metal layer is sandwiched between the low melting point metal layers in the thickness direction, and a heat bonding process for, while the first conductor film and the second conductor film are made to face each other with the low melting point metal layers being interposed therebetween, performing heating at a temperature between the melting points of the first and second high melting point metals and the melting point of the low melting point metal to form an intermetallic compounds of the first and second high melting point metals and the low melting point metals, thereby forming a bonding portion where the first conductor film and the second conductor film are bonded to each other, wherein the high melting point metal contains Cu as the main component, the low melting point metal contains Sn as the main component, and the intermetallic compound formed between the first conductor film and the high melting point layer and the intermetallic compound formed between the second conductor film and the high melting point layer, are $Cu_3Sn$; and wherein the high melting point metal layer formed in the high melting point metal layer forming process has a sufficient thickness such that the high melting point metal is supplied in an amount larger than the amount consumed for the formation of the intermetallic compounds, and the heat bonding process being carried out so that intermetallic compounds of $Cu_3Sn$ are generated and compounds of $CU_6Sn_5$ are prevented, while leaving a part of the high melting point metal layer at the bonding portion.

A corresponding electronic component is also provided.

The low melting point metal layer is provided with a thickness to such an extent that the variation in the interval between the first conductor film and the second conductor film is sufficiently absorbed, and, in the heat bonding process, the high melting point metal layer is sandwiched between the low melting point metal layers in the thickness direction, i.e., the high melting point metal layer is positioned at the middle in the thickness direction of the low melting point metal layers as a bonding material. Thus, the distance in which the high melting point metal is to be diffused in the low melting point metal layers can be shortened, and, in accordance therewith, the time required for diffusing the same can be shortened. As a result, the efficiency of the heat bonding process can be promoted.

The high melting point metal layer has a thickness to such an extent that the high melting point metal can be supplied in an amount larger than the amount consumed for the formation of the intermetallic compound, and thus the high melting point metal can be sufficiently supplied into the low melting point metal layer. Therefore, when both the first and second high melting point metals contain Cu as the main component and the low melting point metal contains Sn as the main component, Cu in a sufficient amount for the formation of $Cu_3Sn$ as the intermetallic compound can be supplied. Thus, the formation of $Cu_6Sn_5$ that is particularly fragile among the intermetallic compounds can be prevented. Therefore, even when a stress originating from, for example, thermal expansion differences occurs between the first component and the second component, the occurrence of cracking due to the distortion, resulting in poor conduction can be prevented.

Moreover, in particular, it takes a long time to diffuse Sn in Cu, and thus the above-described effect for shortening the time is remarkable when the high melting point metal contains Cu as the main component and the low melting point metal contains Sn as the main component.

When the high melting point metal contains Cu as the main component and the low melting point metal contains Sn as the main component, a low melting point metal layer containing Sn as the main component is formed on the first conductor film containing Cu as the main component and, in contrast, a low melting point metal layer containing Sn as the main component is formed on the second conductor film containing Cu as the main component, a high melting point metal layer containing Cu as the main component is formed on the low melting point metal layer, and then a low melting point metal layer containing Sn as the main component is formed on the high melting point metal layer, in order. Thus, at each of the first conductor film side and the second conductor film side, both the high melting point metal layer and the second conductor film each containing, as the main component, Cu that is easily oxidized are covered with the low melting point metal layer containing, as the main component, Sn having a function of preventing oxidation. Therefore, the high melting point metal layer containing Cu as the main component and the second conductor film can be advantageously prevented from oxidation without providing an oxidation preventing film, for example.

When the first component is a main substrate on which a first sealing frame provided by the first conductor film is formed and the second component is a cap substrate on which a second sealing frame provided by the second conductor film is formed, the invention can be advantageously applied for bonding the first sealing frame and the second sealing frame to each other while forming a sealed space between the main substrate and the cap substrate.

In the above-described embodiments, when the first connecting electrode is formed at the position surrounded by the first sealing frame, the second connecting electrode is formed at the position surrounded by the second sealing frame, and the first connecting electrode and the second connecting electrode are electrically connected to each other simultaneously when the first sealing frame and the second sealing frame are bonded to each other, electrical connection and sealing can be simultaneously performed, thereby increasing the productivity of the electronic component device.

The first and second components are prepared by the first and second aggregate substrates, respectively, and the low melting point metal layer forming process, the high melting point metal layer forming process, and the heat bonding process are carried out in a state of the first and second aggregate substrates, the production of a plurality of electronic component devices can be collectively performed. Thus, an increase in the productivity of the electronic component devices can be expected. In general, since the aggregate substrate has a wide area and the in-plane variation in the distance between the sealing frames is likely to become large due to bending of the aggregate substrate, the collective sealing in the aggregate substrate state easily forms a poor sealing portion. However, according to the method for producing an electronic component device according to the invention, the distance between the sealing frames can be increased while keeping the bonding time short. Therefore, even when the in-plane variation occurs, sufficient sealing can be performed throughout the aggregate substrate surface while absorbing the in-plane variation.

According to the electronic component device according to the invention, the high melting point metal layer is present between the first and second intermetallic compounds. The high melting point metal is softer than the intermetallic compound. Therefore, even when a stress originating from thermal expansion differences occurs between the first component and the second component, the high melting point metal layer acts so as to ease the stress, thereby effectively suppressing the bonding portion from breaking.

Brief Description of Drawings

Fig. 1 is a cross sectional view successively illustrating processes provided in a method for producing an electronic component device according to a first embodiment of the invention.
Fig. 2 is a cross sectional view equivalent to Fig. 1(1) for describing a second embodiment of the invention.
Fig. 3 is a cross sectional view equivalent to Fig. 1(1) for describing a third embodiment of the invention.
Fig. 4 is a view illustrating a first example of an electronic component device to which the invention can be applied; in which Fig. 4(a) is a cross sectional view of an electronic component device 31, Fig. 4(b) is a view illustrating a lower principal surface 34 of a cap substrate 33 illustrated in Fig. 4(a), and Fig. 4(c) is a view illustrating an upper principal surface 35 of a main substrate 32 illustrated in Fig. 4(a).
Fig. 5 is a cross sectional view illustrating a second example of an electronic component device to which the invention can be applied.
Fig. 6 is a cross sectional view illustrating a third example of an electronic component device to which the invention can be applied.
Fig. 7 is a cross sectional view successively illustrating processes to be provided in a first former example of a method for producing an electronic component device relevant to the background of the invention.
Fig. 8 is a cross sectional view equivalent to Fig. 7(1) for describing a second former example of the method for producing an electronic component device relevant to the background of the invention.

Reference Numerals

| | |
|---|---|
| 11 | first component |
| 12 | second component |
| 13 | first conductor film |
| 14 | second conductor film |
| 16, 18 | low melting point metal layer |
| 17 | high melting point metal layer |
| 19 to 24 | intermetallic compound layer |
| 25, 44, 57, 69 | bonding portion |
| 31, 51, 61 | electronic component device |
| 32 | main Substrate |
| 33 | cap Substrate |
| 36 | electronic circuit formation portion |
| 37 | first sealing frame |
| 38 | first connecting electrode |
| 39 | second sealing Frame |
| 40 | second connecting electrode |
| 45, 46 | aggregate substrate |

Detailed Description of the Preferred Embodiments

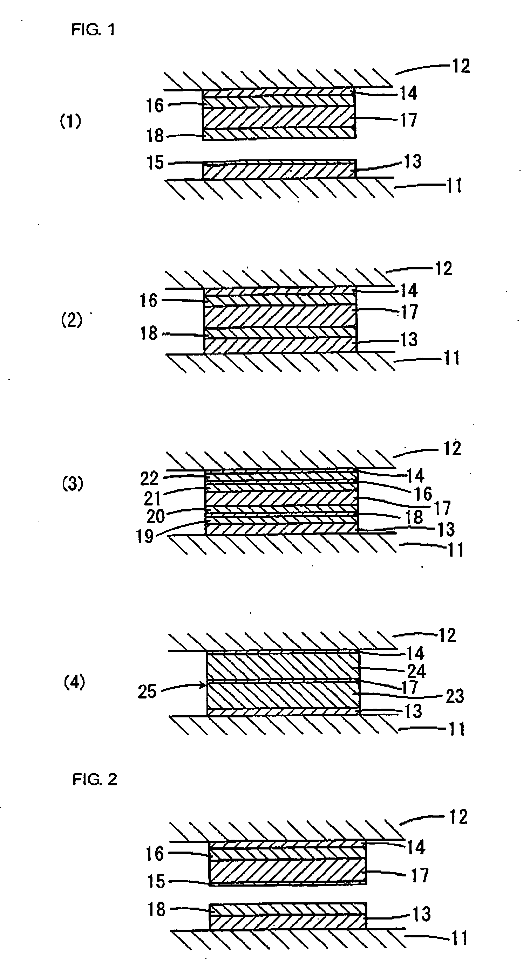

Fig. 1 is a cross sectional view successively illustrating processes provided in a method for producing an electronic component device according to a first embodiment of the invention. Fig. 1 illustrates a process for bonding a first component and a second component 12 to each other that are to be provided in a specific electronic component device. The first and second components 11 and 12 contain silicon, glass, or ceramic, for example.

Fig. 1(1) illustrates a state before the first component 11 and the second component 12 are bonded to each other. On the first component 11, a first conductor film 13 is formed and, in contrast, on the second component 12, a second conductor film 14 is formed. The first and second conductor films 13 and 14 contain first and second high melting point metals, respectively. For simplification of the process, the first and second high melting point metals are preferably the same and, for example, contain Cu as the main component.

As an example, the first conductor film 13 containing Cu as the main component is formed with a thickness of about 4 $\mu$m. However, a film containing Ti may be formed with a thickness of about 0.05 $\mu$m as a base film contacting the first component 11, although not illustrated. As another example, the second conductor film 14 containing Cu as the main component is formed with a thickness of about 4 $\mu$m. However, a film containing Ti having a thickness of about 0.05 $\mu$m may be formed as a base layer contacting the second component 12, although not illustrated.

On the first conductor film 13, an oxidation preventing film 15 containing, for example, Au is formed with a thickness of about 0.1 $\mu$m. The oxidation preventing film 15 prevents oxidation of the first conductor film 13 containing Cu as the main component.

In contrast, on the second conductor film 14, a first low melting point metal layer 16 containing a low melting point metal having a melting point lower than that of the high melting point metal, such as Cu, described above. On the first low melting point metal layer 16, a high melting point metal layer 17 containing the above-described high melting point metal is formed. On the high melting point metal layer 17, a second low melting point metal layer 18 containing the above-described low melting point metal is further formed. The low melting point metal layers 16 and 18 function as a bonding material, and contain, for example, Sn as the main component. The high melting point metal layer 17 contains Cu as the main component similarly as in the conductor films 13 and 14.

As an example, the thickness of the first low melting point metal layer 16 containing Sn as, the main component is adjusted to about 3 $\mu$m, the thickness of the high melting point metal layer 17 containing Cu as the main component is adjusted to about 6 $\mu$m, and the thickness of the second low melting point metal layer 18 containing Sn as the main component is adjusted to about 3 $\mu$m. The thickness of the high melting point metal layer 17 is selected so that the high melting point metal in an amount larger than the amount consumed for the formation of an intermetallic compound can be supplied in a heat bonding process described later.

To the formation of the conductor films 13 and 14, the oxidation preventing film 15, the low melting point metal layers 16 and 18, and the high melting point metal layer 17 described above, film formation methods, such as deposition, sputtering, or metal plating, are applied. Compared with the method for supplying metal powder described in Patent Document 1 previously described above, the film formation methods facilitate the control of the supply amount, i.e., a film thickness, and, according to the film formation methods, the variation in the film thickness is difficult to occur.

Next, the first component 11 and the second component 12 are drawn near to each other and aligned while the first component 11 and the second component 12 are made to face each other as illustrated in Fig. 1(1), and then pressurized. In the pressurization, a pressure of 5 to 10 MPa is supplied. By pressurizing, the oxidation preventing film 15 at the side of the first component 11 and the second low melting point metal layer 18 at the side of the second component 12 contact each other. However, in general, due to the variation in the thickness direction, the oxidation preventing film 15 and the second low melting point metal layer 18 contact each other only at a portion in many cases.

A heat bonding process for performing heating at a temperature between the melting point of Cu as the high melting point metal and the melting point of Sn as the low melting point metal is carried out while maintaining the above-described pressurization state. In the heat bonding process, an inert atmosphere, such as a nitrogen atmosphere or vacuum, is preferably applied, and a temperature increase rate is adjusted to 10°C/minute. The melting point of Sn is 232°C. Thus, the temperature exceeds the melting point, Sn constituting the low melting point metal layers 16 and 18 melts. In this case, due to the pressurization described above, the low melting point metal layers 16 and 18 absorb the variation in the thickness direction while easily deforming, and the oxidation preventing film 15 contacts the second low melting point metal layer 18 over the surface.

For example, when the temperature reaches 260°C, the increase in temperature is stopped, and then the temperature is held. When heated and held as described above, Au constituting the oxidation preventing film 15 dissolves and disappears in molten Sn, the Sn which constitutes the second low melting point metal layer 18. Thus, as illustrated in Fig. 1(2), the first conductor film 13 at the side of the first component 11 contacts the second low melting point metal layer 18 at the side of the second component 12.

When the heating is further continued, a phenomenon in which Cu as the high melting point metal is diffused in molten Sn, the Sn which serves as the low melting point metal, to form an intermetallic compound of Cu and Sn occurs between the first conductor film 13 and the second low melting point metal layer 18, between the second low melting point metal layer 18 and the high melting point metal layer 17, between the high melting point metal layer 17 and the first low melting point metal layers 16, and between the first low melting point metal layer 16 and the second conductor film 14. Therefore, as illustrated in Fig. 1(3), intermetallic compound layers 19, 20, 21, and 22 are formed between the first conductor film 13 and the second low melting point metal layer 18, between the second low melting point metal layer 18 and the high melting point metal layer 17, between the high melting point metal layer 17 and the first low melting point metal layer 16, and between the first low melting point metal layer 16 and the second conductor film 14, respectively.

When the heating described above further continues and the diffusion of Cu in molten Sn further progresses, the first and second low melting point metal layers 16 and 18 disappear, and, as a result, the intermetallic compound layers 19 and 20 are integrated to form a first intermetallic compound layer 23 and the intermetallic compound layers 21 and 22 are integrated to form a second intermetallic compound layer 24, as illustrated in Fig. 1(4).

Thus, a bonding portion 25 in which the first conductor film 13 and the second conductor film 14 are bonded to each other is formed. At the bonding portion 25, the high melting point metal layer 17 partially remains. Therefore, the high melting point metal layer 17 is given, at the beginning of the formation thereof, with a thickness to such an extent that the high melting point metal in an amount larger than the amount consumed for the formation of intermetallic compounds constituting the second intermetallic compound layers 23 and 24 can be supplied.

According to the production method described above, the high melting point metal layer 17 is sandwiched in the thickness direction by the first and second low melting point metal layers 16 and 18 in the heat bonding process while a thickness with which the variation in the interval between the first conductor film 13 and the second conductor film 14 can be sufficiently absorbed is given to the low melting point metal layers 16 and 18. Thus, the distance in which the high melting point metal is to be diffused in each of the low melting point metal layers 16 and 18 can be shortened, and, in accordance therewith, the time required for the diffusion can be shortened.

After the heat bonding process is completed, the resultant is cooled at a temperature decrease rate of, for example, 10°C/minute.

When sufficient Cu is not diffused in molten Sn, $Cu_6Sn_5$ is likely to generate as the intermetallic compound. $Cu_6Sn_5$ is hard and fragile, and thus is unsuitable as the bonding material. More specifically, it is confirmed by an experiment that, when a rupture stress when a shearing stress is applied to the bonding portion under a temperature of 280°C is measured, a rupture stress as low as 62.1 MPa is obtained when $Cu_6Sn_5$ is generated but, when $Cu_3Sn$ is generated, a rupture stress of 230.9 MPa is obtained. Therefore, it is necessary to sufficiently diffuse Cu in molten Sn to generate $Cu_3Sn$ as the intermetallic compound in the heating and bonding process.

As described above, in order to sufficiently diffuse Cu in molten S to generate $Cu_3Sn$, it is important that the thickness of the high melting point metal layer 17 or the like containing Cu as the main component is sufficient and Cu can be sufficiently supplied into Sn.

With respect to each of the conductor films 13 and 14 containing Cu as the main component, the low melting point metal layers 16 and 18 containing Sn as the main component, and the high melting point metal layer 17 containing Cu as the main component, the thickness of the films and the layers formed at a film formation rate determined so that neither nonuniformity nor defects are observed after the formation thereof and the films and the layers can be formed in a time as short as possible is as follows. The ratio of the total thickness of the conductor films 13 and 14 containing Cu as the main component and the high melting point metal layer 17 to the total thickness of the low melting point metal layers 16 and 18 containing Sn as the main component (hereinafter referred to as a "Cu thickness/Sn thickness ratio") is "4/3" or more. When the thicknesses of the first conductor film 13, the second conductor film 14, and the high melting point metal layer 17 satisfy the following relationship represented by the following expressions, Cu in an amount sufficient for generating $Cu_3Sn$ can be supplied into Sn and, after bonding, all of the first conductor film 13, the second conductor film 14, and the high melting point metal layer 17 can be made to remain.

$$\text{(Thickness of First conductor film 13)} > 4/3 \times 1/2 \times \text{(Thickness of Second low melting point metal layer 18)}$$

$$\text{(Thickness of Second conductor film 14)} > 4/3 \times 1/2 \times \text{(Thickness of First low melting point metal layer 16)}$$

$$\text{(Thickness of High melting point metal layer 17)} > 4/3 \times 1/2 \times \text{(Thickness of First low melting point metal layer 16 + Thickness of Second low melting point metal layer 18)}$$

As described above, when the thickness of the first conductor film 13 is 4 μm, the thickness of the second conductor film 14 is 4 μm, the thickness of the first low melting point metal layer 16 is 3 μm, the thickness of the high melting point metal layer 17 is 6 μm, and the thickness of the second low melting point metal layer 18 is 3 μm, the total thickness of the conductor films 13 and 14 containing Cu as the main component and the high melting point metal layer 17 is 14 μm, the total thickness of the low melting point metal layers 16 and 18 containing Sn as the main component is 6 μm, and the Cu thickness/S thickness ratio is "7/3", which is "4/3" or more. Thus, Cu in an amount sufficient for generating $Cu_3Sn$ can be supplied into Sn. The thickness of the first conductor film 13 is 4/3 x 1/2 x (Thickness of second low melting point metal layer 18), i.e., exceeding 2 μm, the thickness of the second conductor film 14 is 4/3 x 1/2 x (Thickness of First low melting point metal layer 16), i.e., exceeding 2 μm, and the thickness of the high melting point metal layer 17 is 4/3 x 1/2 x (Thickness of First low melting point metal layer 16 + Thickness of Second low melting point metal layer 18), i.e., exceeding 4 μm. Thus, after bonding, all of the first conductor film 13, the second conductor film 14, and the high melting point metal layer 17 can be made to remain.

Moreover, the thickness of a layer required for supplying Cu to be diffused to the low melting point metal layers 16 and 18 each having a thickness of 3 μm is 4 μm when following the above-described Cu thickness/Sn thickness ratio. However, at both sides of each of the low melting point metal layers 16 and 18, the layers (the conductor films 13 and 14 and the high melting point metal layer 17) containing Cu as the main component are present. Therefore, a layer having a thickness of 2 μm and containing Cu as the main component may be present at each side of each of the low melting point metal layers 16 and 18. Thus, in the high melting point metal layer 17 having a thickness of 6 μm, an intermetallic compound is generated to a depth of 2 μm from both the surfaces. Thus, the high melting point metal layer 17 containing Cu as the main component remains while having a thickness of 2 μm.

Moreover, in order to sufficiently diffuse Cu in molten Sn to generate $Cu_3Sn$ as described above, a heat retention temperature and a heat retention time in the heat bonding process are also important. When the heat retention temperature and the heat retention time are insufficient, only $Cu_6Sn_5$ generates in some cases. In this case, the formation of $Cu_3Sn$ can be accelerated by further elevating the heat retention temperature or further lengthening the heat retention time. For example, it is confirmed that when heated and held at 260°C, a $Cu_3Sn$ layer having a thickness of about 2 μm is formed by heating and holding for 15 minutes.

The temperature to be applied in the heat bonding process is preferably higher in a permitted range in the electronic component devices. As the heating temperature is higher, the growth rate of $Cu_3Sn$ becomes high, thereby further shortening the time required for bonding.

Fig. 2 is a cross sectional view equivalent to Fig. 1(1) for describing a method for producing an electronic component device according to a second embodiment of the invention. In Fig. 2, components equivalent to those illustrated in Fig. 1 are designated by the same reference characters, and the duplicated descriptions are omitted.

In the embodiment illustrated in Fig. 2, the first component 11 is prepared in a state where the second low melting point metal layer 18 is formed on the first conductor film 13 and the second component 12 is prepared in a state where a low melting point metal layer is not formed on the high melting point metal layer 17 and the oxidation preventing film 15 is formed.

In the second embodiment, when the first component 11 and the second component 12 are drawn near to each other, the heat bonding process is carried out, and Au constituting the oxidation preventing film 15 dissolves in the second low melting point metal layer 18, the cross sectional structure substantially the same as that illustrated in Fig. 1(2) is achieved. Therefore, subsequent processes are the same as those of the first embodiment.

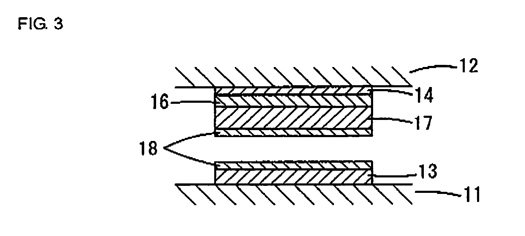

Fig. 3 is a cross sectional view equivalent to Fig. 1 (1) for describing a method for producing an electronic component device according to a third embodiment of the invention. In Fig. 3, components equivalent to those illustrated in Fig. 1 are designated by the same reference characters, and the duplicated descriptions are omitted.

When briefly described, according to the third embodiment, the second low melting point metal layer 18 is divided to two portions in the thickness direction and formed at both sides of the first component 11 and the second component 12, compared with the first embodiment. More specifically, the second low melting point metal layer 18 containing Sn as the main component is formed on the first conductor film 13 containing Cu as the main component. In contrast, the first low melting point metal layer 16 containing Sn as the main component is formed on the second conductor film 14 containing Cu as the main component, the high melting point metal layer 17 containing Cu as the main component is formed on the first low melting point metal layer 16, and the second low melting point metal layer 18 containing Sn as the main component is further formed on the high melting point metal layer 17.

According to the third embodiment, the first conductor film 13 containing Cu as the main component is covered with the second low melting point metal layer 18 containing Sn as the main component. Thus, it is not necessary to form an oxidation preventing film and the use of expensive Au can be avoided.

The invention is described above with reference to the embodiments illustrated in the drawings, but various modifications can be made within the scope of the invention.

For example, in the above-described embodiments, Cu is used as the high melting point metal, butAu, Ag, Ni, etc., may be used in addition to Cu. Moreover, the first high melting point metal constituting the first conductor film 13 and the second high melting point metal constituting the second conductor film 14 may be different from each other. Moreover, the high melting point metals may be used as a pure metal or as a mixture with a slight amount of additives.

In contrast, in the above-described embodiments, Sn is used as the low melting point metal, but In, multi-component Sn-base solder, Pb base solder, etc., may be used in addition to Sn.

In the embodiments illustrated in the drawings, two layers of the low melting point metal layers 16 and 18 sandwiching the high melting point metal layer 17 are used. For example, three or more low melting point metal layers may be used, such as a low melting point metal layer/a high melting point metal layer/a low melting point metal layer/a high melting point metal layer/a low melting point metal layer/a high melting point metal layer, and so on.

The production method according to the invention is applied to a method for producing an electronic component device having a structure in which conductor films containing high melting point metals are bonded to each other using a low melting point metal. As such an electronic component device, filters, oscillators, MEMS (Micro Electro Mechanical Systems) components, etc., are mentioned, for example. As the MEMS components, a gyroscope, an acceleration sensor, etc., are mentioned, for example. Hereinafter, the specific structure of an electronic component device to which the invention can be applied will be described.

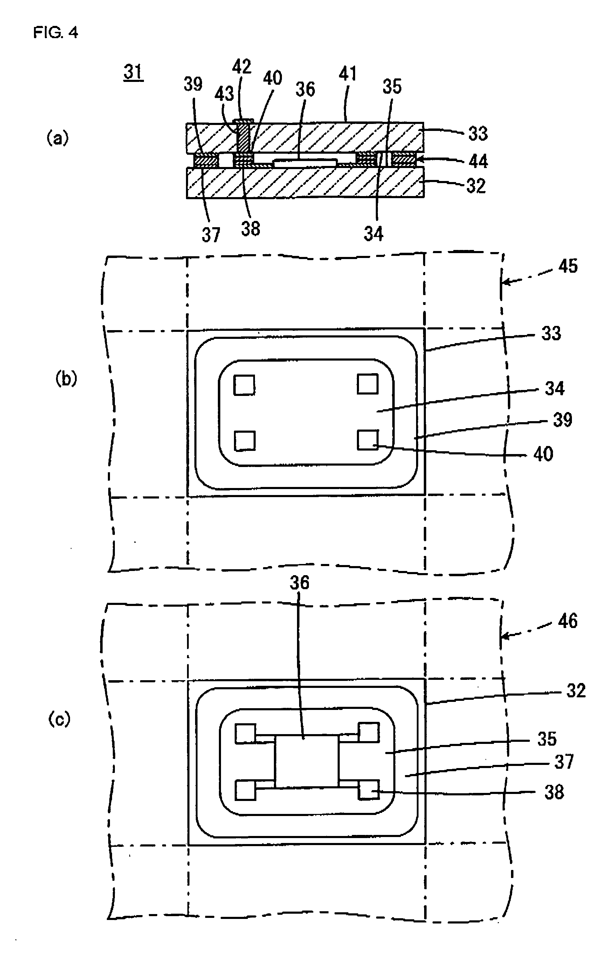

Fig. 4 illustrates a first example of such an electronic component device. The electronic component device 31 illustrated in Fig. 4 has a cross sectional structure as illustrated in 4(a) and has a main substrate 32 and a cap substrate 33 facing the main substrate 32 at a given interval. The structure of a lower principal surface 34 of the cap substrate 33 is illustrated in Fig. 4(b) and the structure of an upper principal surface 35 of the main substrate 32 is illustrated in Fig. 4(c).

On the upper principal surface 35 of the main substrate 32, an electronic circuit formation portion 36 (illustrated in an omitted manner) and a first sealing frame 37 surrounding the electronic circuit formation portion 36 are formed. At a position on the upper principal surface 35 of the main substrate 32 and surrounded by the first sealing frame 37, some first connecting electrodes 38 drawn from the electronic circuit formation portion 36 are formed.

In contrast, on the lower principal surface 34 of the cap substrate 33, a second sealing frame 39 to be bonded to the first sealing frame 37 is formed. At a position on the lower principal surface 34 of the cap substrate 33 and surrounded by the second sealing frame 39, some second connecting electrodes 40 corresponding to the first connecting electrodes 38 are formed. On the upper principal surface 41 of the cap substrate 33, some terminal electrodes 42 are formed. The terminal electrodes 42 are electrically connected to the second connecting electrodes 40 via through hole conductors 43 formed in such a manner as to penetrate the cap substrate 33 in the thickness direction.

For the production of such an electronic component device 31, the production method described with reference to Fig. 1 or the like is applied. The equivalent relationship between the electronic component device 31 and the components illustrated in Fig. 1 is as follows: the main substrate 32 is equivalent to the first component 11 and the cap substrate 33 is equivalent to the second component 12. The first sealing frame 37 is equivalent to the first conductor film 13 and the second sealing frame 39 is equivalent to the second conductor film 14. In order to bond the first sealing frame 37 and second sealing frame 39 to each other, the method illustrated in Fig. 1 is applied. In Fig. 4(a), the bonding portion 44 is illustrated in an omitted manner.

Preferably, a process for electrically connecting the first connecting electrodes 38 and the second connecting electrodes 40 to each other is carried out simultaneously with a heat bonding process for bonding the first sealing frame 37 and second sealing frame 39 to each other. In this case, also in the first connecting electrode and the second connecting electrode 40, the same cross sectional structure as in the case of the first sealing frame 37 and the second sealing frame 39 may be applied.

The main substrate 32 and the cap substrate 33 are prepared in the state of the aggregate substrates 45 and 46 as illustrated by the phantom lines in Figs. 4(c) and 4(b), respectively. In the state of the aggregate substrates 45 and 46, the low melting point metal layer forming process, the high melting point metal layer forming process, and the heat bonding process previously described above are carried out. In order to take out a plurality of the main substrates 32 and the cap substrates 33, the aggregate substrates 45 and 46 may be divided after the heat bonding process.

When the intermetallic compound layer formed at the bonding portion 44 contains Cu$_3$Sn in the electronic component device 31 illustrated in Fig. 4 as described above, the electronic circuit formation portion 36 and the like surrounded by the sealing frames 37 and 39 are hermetically sealed with high reliability because the Cu$_3$Sn has a dense structure.

The melting point of Cu$_3$Sn is as high as 676°C. Thus, even when reflow (peak temperature: about 260°C) is applied for surface mounting of the electronic component device 31, high reliability can be maintained in the electrical conduction properties and hermetical sealing properties while not causing re-melting at the bonding potion 44.

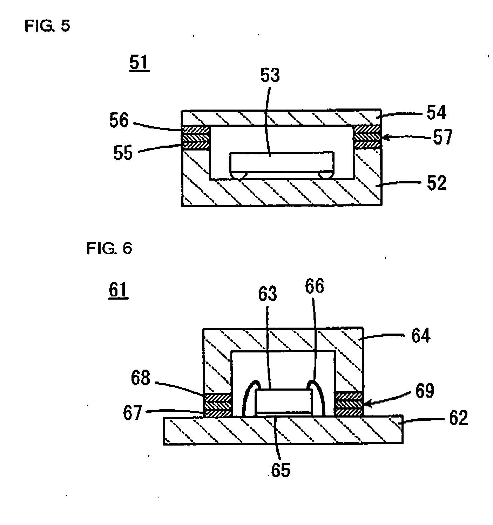

Figs. 5 and 6 illustrate the second and third examples of the electronic component device to which the invention can be applied in the cross sectional views, respectively.

An electronic component device 51 illustrated in Fig. 5 has a structure in which a lid 54 is bonded to a ceramic package 52 in order to accommodate an electronic component chip 53 in the ceramic package 52 and seal the electronic component chip 53. The electronic component chip 53 is flip-chip mounted on the ceramic package 52.

In order to produce such an electronic component device 51, the production method described with reference to Fig. 1 or the like is applied. The equivalent relationship between the electronic component device 51 and the components illustrated in Fig. 1 is as follows: the ceramic package 52 is equivalent to the first component 11 and the lid 54 is equivalent to the second component 12. A first conductor film 55 equivalent to the first conductor film 13 is formed at the peripheral edge portion of an opening of the ceramic package 52 and a second conductor film 56 equivalent to the second conductor film 14 is formed at the bottom surface of the lid 54. In order to bond the first conductor film 55 and the second conductor film 56 to each other, the method as illustrated in Fig. 1 or the like is applied. In Fig. 5, the bonding portion 57 is illustrated in an omitted manner.

An electronic component device 61 illustrated in Fig. 6 has a structure in which an electronic component chip 63 is mounted on a substrate 62 and a shield case 64 is bonded to the substrate 62 for shielding and sealing the electronic component chip 63. The electronic component chip 63 is mechanically fixed to the substrate 62 through a bonding material 65 and also is electrically connected thereto by wire bonding 66.

In order to produce such an electronic component device 61, the production method described with reference to Fig. 1 or the like is applied. The equivalent relationship between the electronic component device 61 and the components illustrated in Fig. 1 is as follows: the substrate 62 is equivalent to the first component 11 and the shielding case 64 is equivalent to the second component 12. A first conductor film 67 equivalent to the first conductor film 13 is formed on the upper surface of the substrate 62 and a second conductor film 68 equivalent to the second conductor film 14 is formed at the peripheral edge portion of an opening of the seal and case 64. In order to bond the first conductor film 67 and the second conductor film 68 to each other, the method illustrated in Fig. 1 is applied. In Fig. 5, the bonding portion 69 is illustrated in an omitted manner.

**Claims**

1. A method for producing an electronic component device, comprising:

   a process for individually preparing a first component (11) on which a first conductor film (13) containing a first high melting point metal is formed and a second component (12) on which a second conductor film (14) containing a second high melting point metal is formed, wherein the first high melting point metal and the second high melting point metal are the same;
   a low melting point metal layer forming process for forming, on at least one of the first and second conductor films (13,14), a first low melting point metal layer (16) containing a low melting point metal having a melting point lower than that of the first and second high melting point metals; and

a high melting point metal layer forming process for forming a high melting point metal layer (17) containing the same high melting point metal as the first and second high melting point metals in such a manner as to contact the low melting point metal layer (16),

the low melting point metal layer forming process further including a process for forming a second low melting point metal layer (18) in such a manner that the high melting point metal layer (17) is sandwiched between the low melting point metal layers (16,18) in the thickness direction,

and a heat bonding process for, while the first conductor film (13) and the second conductor film (14) are made to face each other with the low melting point metal layers (16, 18) being interposed therebetween, performing heating at a temperature between the melting points of the first and second high melting point metals and the melting point of the low melting point metal to form an intermetallic compounds of the first and second high melting point metals and the low melting point metals, thereby forming a bonding portion where the first conductor film (13) and the second conductor film (14) are bonded to each other,

wherein the high melting point metal contains Cu as the main component, the low melting point metal contains Sn as the main component, and the intermetallic compound (23) formed between the first conductor film (13) and the high melting point layer (17) and the intermetallic compound (24) formed between the second conductor film (14) and the high melting point layer (17), are $Cu_3Sn$; and

wherein the high melting point metal layer (17) formed in the high melting point metal layer forming process has a sufficient thickness such that the high melting point metal is supplied in an amount larger than the amount consumed for the formation of the intermetallic compounds, and the heat bonding process being carried out so that intermetallic compounds of $Cu_3Sn$ are generated and compounds of $CU_6Sn_5$ are prevented, while leaving a part of the high melting point metal layer (17) at the bonding portion.

2. The method of claim 1, wherein the second low melting point metal layer (18) is formed on the first conductor film (13) and, the first low melting point metal layer (16) is formed on the second conductor film (14), the high melting point metal layer (17) is formed on the first low melting point metal layer (16), and then the second low melting point metal layer (18) is formed on the high melting point metal layer, in order.

3. The method of claim 1 or 2, comprising forming an oxide-prevention forming layer (15) on the first conductor film (13), before carrying out the heat bonding process step.

4. The method of claim 1, wherein the second low melting point metal layer (18) is formed on the first conductor film (13) and, the first low melting point metal layer (16) is formed on the second conductor film (14), the high melting point metal layer (17) is formed on the first low melting point metal layer (16).

5. The method of claim 4, comprising forming an oxide-prevention forming layer (15) on high melting point metal layer (17).

6. The method of claim 4, comprising forming a third oxide-prevention forming a third low melting point metal layer (18) on the high melting point metal layer (17).

7. The method for producing an electronic component device according to claim 1, which is applied for bonding the first sealing frame and the second sealing frame to each other, wherein

the first component is a main substrate on one principal surface of which an electronic circuit formation portion and a first sealing frame surrounding the electronic circuit formation portion are formed and the second component is a cap substrate on one principal surface of which a second sealing frame to be bonded to the first sealing frame is formed, and

the first sealing frame is provided by the first conductor film and the second sealing frame is provided by the second conductor film.

8. The method for producing an electronic component device according to claim 9, wherein a first connecting electrode is formed at a position on the one principal surface of the main substrate and surrounded by the first sealing frame, a second connecting electrode is formed at a position on the one principal surface of the cap substrate and surrounded by the second sealing frame, and a process for electrically connecting the first connecting electrode and the second connecting electrode to each other is performed simultaneously with the heat bonding process.

9. The method for producing an electronic component device according to any one of claims 1 to 8, wherein the process for individually preparing the first and second components includes a process for preparing a first aggregate substrate and a second aggregate substrate, the first aggregate substrate and a second aggregate substrate individually providing a plurality of the first and second components, the low melting point metal layer forming process, the high melting point metal layer forming process, and the heat bonding process are carried out in a state of the first and second aggregate substrates, and, in order to take out the plurality of the first and second components, a process for dividing the first and second aggregate substrates is further included after the heat bonding process.

10. The method of claim 1, wherein the intermetallic compound of Cu and Sn formed between the first conductor film (13) and the second low melting point metal layer (18), between the second low melting point metal layer (18) and the high melting point layer (17), between the high melting point layer (17) and the first low melting point metal layer (16), and between the first low melting point metal layer (16) and the first conductor film (14) is formed by the diffusion of Cu as the high melting point metal into molten Sn.

11. An electronic component device, formed by the method of any of claims 1 to 10, comprising:

a first component (11) on which a first conductor film (13) containing a first high melting point metal is formed, a second component (12) on which a second conductor film (14) containing a second high melting point metal is formed, wherein the first high melting point metal and the second high melting point metal are the same; and a bonding portion (17, 23, 24) for bonding the first conductor film and the second conductor film to each other, the bonding portion containing a first intermetallic compound layer (23) containing an intermetallic compound of the first high melting point metal and a low melting point metal having a melting point lower than that of the first and second high melting point metals, a second intermetallic compound layer (24) containing an intermetallic compound of the second high melting point metal and the low melting point metal, and a high melting point metal layer (17) that is positioned between the first and second intermetallic compound layers and that contains one of the first and second high melting point metals, wherein the high melting point metal contains Cu as the main component, the low melting point metal contains Sn as the main component, and the intermetallic compound formed between the first conductor film (13) and the high melting point layer (17) and the intermetallic compound formed between the second conductor film (14) and the high melting point layer (17), are $Cu_3Sn$.

## Patentansprüche

1. Verfahren zum Produzieren einer elektronischen Bauelementvorrichtung, das Folgendes aufweist:

einen Prozess zum einzelnen Anfertigen eines ersten Bauelements (11), auf dem ein erster Leiterfilm (13), der ein erstes Metall mit hohem Schmelzpunkt enthält, ausgebildet ist, und eines zweiten Bauelements (12), auf dem ein zweiter Leiterfilm (14), der ein zweites Metall mit hohem Schmelzpunkt enthält, ausgebildet ist, wobei das erste Metall mit hohem Schmelzpunkt und das zweite Metall mit hohem Schmelzpunkt die gleichen sind; einen Prozess zum Bilden einer Schicht aus Metall mit niedrigem Schmelzpunkt zum Bilden, an wenigstens einem des ersten und des zweiten Leiterfilms (13, 14), einer ersten Schicht aus Metall mit niedrigem Schmelzpunkt (16), die ein Metall mit niedrigem Schmelzpunkt enthält, das einen Schmelzpunkt hat, der niedriger ist als der des ersten und des zweiten Metalls mit hohem Schmelzpunkt; und einen Prozess zum Bilden einer Schicht aus Metall mit hohem Schmelzpunkt zum Bilden einer Schicht aus Metall mit hohem Schmelzpunkt (17), die das gleiche Metall mit hohem Schmelzpunkt wie das erste und das zweite Metall mit hohem Schmelzpunkt enthält, auf eine solche Weise, dass sie die Schicht aus Metall mit niedrigem Schmelzpunkt (16) berührt, wobei der Prozess zum Bilden einer Schicht aus Metall mit niedrigem Schmelzpunkt ferner einen Prozess zum Bilden einer zweiten Schicht aus Metall mit niedrigem Schmelzpunkt (18) auf eine solche Weise, dass die Schicht aus Metall mit hohem Schmelzpunkt (17) in der Dickenrichtung zwischen die Schichten aus Metall mit niedrigem Schmelzpunkt (16, 18) zwischengelegt ist, beinhaltet, und einen thermischen Fügeprozess zum Durchführen, während der erste Leiterfilm (13) und der zweite Leiterfilm (14) bei Anordnung der Schichten aus Metall mit niedrigem Schmelzpunkt (16, 18) dazwischen dazu gebracht werden, einander zugekehrt werden, einer Erwärmung auf eine Temperatur zwischen den Schmelzpunkten des ersten und des zweiten Metalls mit hohem Schmelzpunkt und dem Schmelzpunkt des Metalls mit niedrigem Schmelzpunkt zum Bilden einer intermetallischen Verbindung des ersten und des zweiten Metalls mit hohem Schmelzpunkt und der Metalle mit niedrigem Schmelzpunkt, wodurch ein Fügeteil gebildet wird, wo der erste Leiterfilm (13) und der zweite Leiterfilm (14) aneinander angefügt sind, wobei das Metall mit hohem Schmelzpunkt Cu als die Hauptkomponente enthält, das Metall mit niedrigem Schmelzpunkt Sn als die Hauptkomponente enthält und die zwischen dem ersten Leiterfilm (13) und der Schicht mit hohem Schmelzpunkt (17) gebildete intermetallische Verbindung (23) und die zwischen dem zweiten Leiterfilm (14) und der Schicht mit hohem Schmelzpunkt (17) gebildete intermetallische Verbindung (24) $Cu_3Sn$ sind; und

wobei die im Prozess zum Bilden einer Schicht aus Metall mit hohem Schmelzpunkt gebildete Schicht aus Metall mit hohem Schmelzpunkt (17) eine ausreichende Dicke hat, so dass das Metall mit hohem Schmelzpunkt in einer größeren Menge zugeführt wird als der für die Bildung der intermetallischen Verbindungen verbrauchten Menge und der thermische Fügeprozess durchgeführt wird, so dass intermetallische Verbindungen von $CU_3Sn$ erzeugt werden und Verbindungen von $CU_6Sn_5$ verhütet werden, während ein Teil der Schicht aus Metall mit hohem Schmelzpunkt (17) am Fügeteil belassen wird.

2. Verfahren nach Anspruch 1, wobei der Reihe nach die zweite Schicht aus Metall mit niedrigem Schmelzpunkt (18) auf dem ersten Leiterfilm (13) ausgebildet wird und die erste Schicht aus Metall mit niedrigem Schmelzpunkt (16) auf dem zweiten Leiterfilm (14) ausgebildet wird, die Schicht aus Metall mit hohem Schmelzpunkt (17) auf der ersten Schicht aus Metall mit niedrigem Schmelzpunkt (16) ausgebildet wird und dann die zweite Schicht aus Metall mit niedrigem Schmelzpunkt (18) auf der Schicht aus Metall mit hohem Schmelzpunkt ausgebildet wird.

3. Verfahren nach Anspruch 1 oder 2, das das Bilden einer eine Oxidationshemmung bildenden Schicht (15) auf dem ersten Leiterfilm (13) vor Durchführung des Prozessschritts des thermischen Fügens aufweist.

4. Verfahren nach Anspruch 1, wobei die zweite Schicht aus Metall mit niedrigem Schmelzpunkt (18) auf dem ersten Leiterfilm (13) ausgebildet wird und die erste Schicht aus Metall mit niedrigem Schmelzpunkt (16) auf dem zweiten Leiterfilm (14) ausgebildet wird, die Schicht aus Metall mit hohem Schmelzpunkt (17) auf der ersten Schicht aus Metall mit niedrigem Schmelzpunkt (16) ausgebildet wird.

5. Verfahren nach Anspruch 4, das das Bilden einer eine Oxidationshemmung bildenden Schicht (15) auf der Schicht aus Metall mit hohem Schmelzpunkt (17) aufweist.

6. Verfahren nach Anspruch 4, das das Bilden einer dritten Oxidationshemmung aufweist, die eine dritte Schicht aus Metall mit niedrigem Schmelzpunkt (18) auf der Schicht aus Metall mit hohem Schmelzpunkt (17) bildet.

7. Verfahren zum Produzieren einer elektronischen Bauelementvorrichtung nach Anspruch 1, das zum Fügen des ersten Dichtungsrahmens und des zweiten Dichtungsrahmens aneinander angewendet wird, wobei die erste Komponente ein Hauptsubstrat ist, wobei auf einer Hauptfläche davon ein eine elektronische Schaltung bildender Teil und ein den eine elektronische Schaltung bildenden Teil umgebender erster Dichtungsrahmen ausgebildet wird, und die zweite Komponente ein Deckelsubstrat ist, wobei auf einer Hauptfläche davon ein an den ersten Dichtungsrahmen anzufügender zweiter Dichtungsrahmen ausgebildet wird, und der erste Dichtungsrahmen von dem ersten Leiterfilm bereitgestellt wird und der zweite Dichtungsrahmen von dem zweiten Leiterfilm bereitgestellt wird.

8. Verfahren zum Produzieren einer elektronischen Bauelementvorrichtung nach Anspruch 9, wobei eine erste Verbindungselektrode an einer Position auf der einen Hauptfläche des Hauptsubstrats gebildet und mit dem ersten Dichtungsrahmen umgeben wird, eine zweite Verbindungselektrode an einer Position auf der einen Hauptfläche des Deckelsubstrats gebildet und mit dem zweiten Dichtungsrahmen umgeben wird und ein Prozess zum elektrischen Verbinden der ersten Verbindungselektrode und der zweiten Verbindungselektrode miteinander gleichzeitig mit dem thermischen Fügeprozess durchgeführt wird.

9. Verfahren zum Produzieren einer elektronischen Bauelementvorrichtung nach einem der Ansprüche 1 bis 8, wobei der Prozess zum einzelnen Anfertigen der ersten und der zweiten Komponenten einen Prozess zum Anfertigen eines ersten Aggregatsubstrats und eines zweiten Aggregatsubstrats beinhaltet, wobei das erste Aggregatsubstrat und ein zweites Aggregatsubstrat einzeln mehrere der ersten und zweiten Komponenten bereitstellen, der Prozess des Bildens einer Schicht aus Metall mit niedrigem Schmelzpunkt, der Prozess des Bildens einer Schicht aus Metall mit hohem Schmelzpunkt und der thermische Fügeprozess in einem Zustand des ersten und des zweiten Aggregatsubstrats durchgeführt werden und nach dem thermischen Fügeprozess des Weiteren ein Prozess zum Unterteilen des ersten und zweien Aggregatsubstrats eingeschlossen ist, um die mehreren der ersten und zweiten Komponenten herauszunehmen.

10. Verfahren nach Anspruch 1, wobei die zwischen dem ersten Leiterfilm (13) und der zweiten Schicht aus Metall mit niedrigem Schmelzpunkt (18), zwischen der zweiten Schicht aus Metall mit niedrigem Schmelzpunkt (18) und der Schicht aus Metall mit hohem Schmelzpunkt (17), zwischen der Schicht aus Metall mit hohem Schmelzpunkt (17) und der ersten Schicht aus Metall mit niedrigem Schmelzpunkt (16) und zwischen der ersten Schicht aus Metall mit niedrigem Schmelzpunkt (16) und dem ersten Leiterfilm (14) gebildete intermetallische Verbindung aus Cu und Sn durch die Diffusion von Cu als dem Metall mit hohem Schmelzpunkt in geschmolzenes Sn gebildet wird.

11. Elektronische Bauelementvorrichtung, die mit dem Verfahren nach einem der Ansprüche 1 bis 10 hergestellt ist, umfassend:

ein erstes Bauelement (11), auf dem ein erster Leiterfilm (13), der ein erstes Metall mit hohem Schmelzpunkt enthält, ausgebildet ist, ein zweites Bauelement (12), auf dem ein zweiter Leiterfilm (14), der ein zweites Metall mit hohem Schmelzpunkt enthält, ausgebildet ist, wobei das erste Metall mit hohem Schmelzpunkt und das zweite Metall mit hohem Schmelzpunkt die gleichen sind; und

einen Fügeteil (17, 23, 24) zum Fügen des ersten Leiterfilms und des zweiten Leiterfilms aneinander, wobei der Fügeteil eine erste intermetallische Verbindungsschicht (23), die eine intermetallische Verbindung des ersten Metalls mit hohem Schmelzpunkt und eines Metalls mit niedrigem Schmelzpunkt, das einen Schmelzpunkt hat, der niedriger als der des ersten und des zweiten Metalls mit hohem Schmelzpunkt ist, eine zweite intermetallische Verbindungsschicht (24), die eine intermetallische Verbindung des zweiten Metalls mit hohem Schmelzpunkt und des Metalls mit niedrigem Schmelzpunkt enthält, und eine Schicht aus Metall mit hohem Schmelzpunkt (17) enthält, die zwischen der ersten und der zweiten intermetallischen Verbindungsschicht positioniert ist und die eines von dem ersten und dem zweiten Metall mit hohem Schmelzpunkt enthält,

wobei das Metall mit hohem Schmelzpunkt Cu als die Hauptkomponente enthält, das Metall mit niedrigem Schmelzpunkt Sn als die Hauptkomponente enthält und die zwischen dem ersten Leiterfilm (13) und der Schicht mit hohem Schmelzpunkt (17) gebildete intermetallische Verbindung und die zwischen dem zweiten Leiterfilm (14) und der Schicht mit hohem Schmelzpunkt (17) gebildete intermetallische Verbindung (24) $Cu_3Sn$ sind.

## Revendications

1. Procédé de production d'un appareil à composants électroniques, comprenant :

un procédé pour préparer individuellement un premier composant (11) sur lequel un premier film conducteur (13) contenant un premier métal à haut point de fusion est formé et un deuxième composant (12) sur lequel un deuxième film conducteur (14) contenant un deuxième métal à haut point de fusion est formé, dans lequel le premier métal à haut point de fusion et le deuxième métal à haut point de fusion sont les mêmes ;

un procédé de formation d'une couche de métal à bas point de fusion pour former, sur au moins l'un d'entre le premier et le deuxième film conducteur (13, 14), une première couche de métal à bas point de fusion (16) contenant un métal à bas point de fusion ayant un point de fusion plus bas que les premier et deuxième métaux à haut point de fusion ; et

un procédé de formation de couche de métal à haut point de fusion pour former une couche de métal à haut point de fusion (17) contenant le même métal à haut point de fusion que les premier et deuxième métaux à haut point de fusion d'une façon telle à entrer en contact avec la couche de métal à bas point de fusion (16), le procédé de formation de couche de métal à bas point de fusion comprenant en outre un procédé pour former une deuxième couche de métal à bas point de fusion (18) d'une façon telle que la couche de métal à haut point de fusion (17) est en sandwich entre les couches de métal à bas point de fusion (16, 18) dans la direction de l'épaisseur,

et un procédé de liaison thermique pour, tandis que le premier film conducteur (13) et le deuxième film conducteur (14) sont placés l'un face à l'autre avec les couches de métal à bas point de fusion (16, 18) étant interposées entre eux, effectuer un chauffage à une température entre les points de fusion des premier et deuxième métaux à haut point de fusion et les points de fusion du métal à bas point de fusion afin de former un composé intermétallique des premier et deuxième métaux à haut point de fusion et des métaux à bas point de fusion, formant ainsi une partie de liaison dans laquelle le premier film conducteur (13) et le deuxième film conducteur (14) sont liés l'un à l'autre,

où le métal à haut point de fusion contient du Cu en tant que composant principal, le métal à bas point de fusion contient du Sn en tant que composant principal, et le composé intermétallique (23) formé entre le premier film conducteur (13) et la couche à haut point de fusion (17) et le composé intermétallique (24) formé entre le deuxième film conducteur (14) et la couche à haut point de fusion (17), sont du $Cu_3Sn$ ; et

où la couche de métal à haut point de fusion (17) formée dans le procédé de formation de couche de métal à haut point de fusion a une épaisseur suffisante de telle sorte que le métal à haut point de fusion est fourni en une plus grande quantité que la quantité consommée pour la formation des composés intermétalliques, et le procédé de liaison thermique étant effectué de façon telle que des composés intermétalliques de $Cu_3Sn$ sont produits et des composés de $Cu_6Sn_5$ sont évités, tout en laissant une partie de la couche de métal à haut point de fusion (17) à la partie de liaison.

2. Procédé selon la revendication 1, dans lequel la deuxième couche de métal à bas point de fusion (18) est formée sur le premier film conducteur (13) et, la première couche de métal à bas point de fusion (16) est formée sur le deuxième film conducteur (14), la couche de métal à haut point de fusion (17) est formée sur la première couche de métal à bas point de fusion (16), et puis la deuxième couche de métal à bas point de fusion (18) est formée sur la couche de métal à haut point de fusion, dans l'ordre.

3. Procédé selon la revendication 1 ou 2, comprenant former une couche de prévention de formation d'oxydation (15) sur le premier film conducteur (13) avant d'effectuer l'étape du procédé de liaison thermique.

4. Procédé selon la revendication 1, dans lequel la deuxième couche de métal à bas point de fusion (18) est formée sur le premier film conducteur (13) et, la première couche de métal à bas point de fusion (16) est formée sur le deuxième film conducteur (14), la couche de métal à haut point de fusion (17) est formée sur la première couche de métal à bas point de fusion (16).

5. Procédé selon la revendication 4, comprenant former une couche de prévention de formation d'oxydation (15) sur la couche de métal à haut point de fusion (17).

6. Procédé selon la revendication 4, comprenant former une troisième couche de métal à bas point de fusion (18) formant une troisième prévention d'oxydation sur la couche de métal à haut point de fusion (17).

7. Procédé de production d'un dispositif à composants électroniques selon la revendication 1, lequel est appliqué pour lier le premier châssis d'étanchéité et le deuxième châssis d'étanchéité l'un à l'autre, dans lequel
le premier composant est un substrat principal sur une surface principale de laquelle une partie de formation de circuit électronique et un premier châssis d'étanchéité entourant la partie de formation de circuit électronique sont formés et le deuxième composant est un substrat d'encapsulation sur une surface principale de laquelle un deuxième châssis d'étanchéité devant être lié au premier châssis d'étanchéité, est formé, et
le premier châssis d'étanchéité est fourni par le premier film conducteur et le deuxième châssis d'étanchéité est fourni par le deuxième film conducteur.

8. Procédé de production d'un dispositif à composants électroniques selon la revendication 9, dans lequel une première électrode de connexion est formée à une position sur la une surface principale du substrat principal et entourée par le premier châssis d'étanchéité, une deuxième électrode de connexion est formée à une position sur la une surface principale du substrat d'encapsulation et entourée par le deuxième châssis d'étanchéité, et un procédé pour connecter électriquement la première électrode de connexion et la deuxième électrode de connexion l'une à l'autre est effectué simultanément avec le procédé de liaison thermique.

9. Procédé de production d'un dispositif à composants électroniques selon l'une quelconque des revendications 1 à 8, dans lequel
le procédé pour préparer individuellement le premier et le deuxième composant comprend un procédé pour préparer un premier substrat agrégé et un deuxième substrat agrégé, le premier substrat agrégé et un deuxième substrat agrégé fournissant individuellement une pluralité des premier et deuxième composants, le procédé de formation de couche de métal à bas point de fusion, le procédé de formation de couche de métal à haut point de fusion, et le procédé de liaison thermique sont effectués dans un état des premier et deuxième substrats agrégés et, afin de retirer la pluralité de premiers et de deuxièmes composants, un procédé pour diviser les premier et deuxième substrats agrégés est inclus en plus après le procédé de liaison thermique.

10. Procédé selon la revendication 1, dans lequel le composé intermétallique de Cu et de Sn formé entre le premier film conducteur (13) et la deuxième couche de métal à bas point de fusion (18), entre la deuxième couche de métal à bas point de fusion (18) et la couche de métal à haut point de fusion (17), entre la couche à haut point de fusion (17) et la première couche de métal à bas point de fusion (16), et entre la première couche de métal à bas point de fusion (16) et le premier film conducteur (14), est formé par la diffusion de Cu comme le métal à haut point de fusion dans du Sn fondu.

**11.** Dispositif à composants électroniques, formé par le procédé selon l'une quelconque des revendications 1 à 10, comprenant :

un premier composant (11) sur lequel un premier film conducteur (13) contenant un premier métal à haut point de fusion est formé, un deuxième composant (12) sur lequel un deuxième film conducteur (14) contenant un deuxième métal à haut point de fusion est formé, où le premier métal à haut point de fusion et le deuxième métal à haut point de fusion sont les mêmes; et

une partie de liaison (17, 23, 24) pour lier le premier film conducteur et le deuxième film conducteur l'un à l'autre, la partie de liaison contenant une première couche de composé intermétallique (23) contenant un composé intermétallique du premier métal à haut point de fusion et un métal à bas point de fusion ayant un point de fusion plus bas que celui du premier et du deuxième métal à haut point de fusion, une deuxième couche de composé intermétallique (24) contenant un composé intermétallique du deuxième métal à haut point de fusion et du métal à bas point de fusion, et une couche de métal à haut point de fusion (17) qui est positionnée entre les première et deuxième couches de composé intermétallique et qui contient l'un des premier et deuxième métaux à haut point de fusion,

où le métal à haut point de fusion contient du Cu comme composant principal, le métal à bas point de fusion contient du Sn comme composant principal, et le composé intermétallique formé entre le premier film conducteur (13) et la couche à haut point de fusion (17) et le composé intermétallique formé entre le deuxième film conducteur (14) et la couche à haut point de fusion (17) sont du $Cu_3Sn$.

FIG. 1

FIG. 2

FIG. 3

FIG. 4

FIG. 5

<u>51</u>

53

56
55
54
57
52

FIG. 6

<u>61</u>

63    66

64

68
67
69
62

65

FIG. 7

(1)

(2)

(3)

(4)

FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002110726 A
- JP 2007019360 A
- US 20060186550 A
- US 20060138532 A
- US 20070089811 A